# EUROPEAN PATENT SPECIFICATION

(11) **EP 2 811 538 B1**
(45) Date of publication and mention of the grant of the patent: **06.05.2020**
(21) Application number: 13743766.1
(22) Date of filing: 31.01.2013
(51) Int. Cl.: H01L 31/042, H01L 31/18, H01L 31/032

(54) **METHOD FOR MANUFACTURING PHOTOVOLTAIC CI(G)S-BASED THIN FILM USING FLUX HAVING LOW MELTING POINT**
VERFAHREN ZUR HERSTELLUNG EINER PHOTOVOLTAISCHEN CI(G)S-DÜNNSCHICHT MITHILFE EINES DURCHFLUSSES MIT NIEDRIGEM SCHMELZPUNKT
PROCÉDÉ DE FABRICATION D'UN MINCE FILM PHOTOVOLTAÏQUE À BASE DE CI(G)S À L'AIDE D'UN FLUX QUI PRÉSENTE UN POINT DE FUSION BAS

(30) Priority: 02.02.2012 KR 20120010638
(43) Date of publication of application: 10.12.2014
(73) Proprietor: Korea Institute of Energy Research, Daejeon 305-343 (KR)
(72) Inventor: EO, Young-Joo, Daejeon 305-509 (KR); YOON, Kyung-Hoon, Daejeon 305-340 (KR); AHN, SeJin, Daejeon 305-768 (KR); GWAK, Jihye, Daejeon 302-120 (KR); YUN, Jae-Ho, Daejeon 301-150 (KR); CHO, Ara, Seoul 151-050 (KR); SHIN, Kee-Shik, Daejeon 305-762 (KR); AHN, SeoungKyu, Daejeon 305-807 (KR); CHO, Jun-Sik, Daejeon 305-768 (KR); YOO, Jin-Su, Seoul 139-957 (KR); PARK, Sang-Hyun, Daejeon 305-750 (KR); PARK, Joo-Hyung, Daejeon 305-330 (KR)
(74) Representative: Carpintero Lopez, Francisco
(86) International application number: PCT/KR2013/000804
(87) International publication number: WO 2013/115582

(56) References cited:
- WO-A2-2012/011723
- KR-A- 20090 029 495
- KR-A- 20090 092 471
- KR-A- 20100 034 817
- KR-A- 20110 052 473
- KR-A- 20110 107 673
- US-A1- 2007 163 644
- US-A1- 2010 307 556
- CASTELEYN M ET AL: "SCREEN PRINTED AND SINTERED CuInSe2 BASED CHALCOPYRITE LAYERS FOR SOLAR CELLS", 12TH. E.C. PHOTOVOLTAIC SOLAR ENERGY CONFERENCE. AMSTERDAM, THE NETHERLANDS, APRIL 11 - 15, 1994; [PROCEEDINGS OF THE INTERNATIONAL PHOTOVOLTAIC SOLAR ENERGY CONFERENCE], BEDFORD : H.S. STEPHENS & ASSOCIATES, GB, vol. CONF. 12, 11 April 1994 (1994-04-11), pages 604-607, XP001136812, ISBN: 978-0-9521452-4-0
- TEODOR K. TODOROV ET AL: "High-Efficiency Solar Cell with Earth-Abundant Liquid-Processed Absorber", ADVANCED MATERIALS, vol. 22, no. 20, 25 May 2010 (2010-05-25), pages 156-159, XP055001255, ISSN: 0935-9648, DOI: 10.1002/adma.200904155
- MITZI D B ET AL: "Hydrazine-based deposition route for device-quality CIGS films", THIN SOLID FILMS, ELSEVIER-SEQUOIA S.A. LAUSANNE, CH, vol. 517, no. 7, 2 February 2009 (2009-02-02), pages 2158-2162, XP025928587, ISSN: 0040-6090, DOI: 10.1016/J.TSF.2008.10.079 [retrieved on 2008-11-06]

## Description

### Technical Field

The present invention relates to a method for fabricating a CI (G) S-based thin film for a solar cell, and more particularly to a method for fabricating a CI (G) S-based thin film using a non-vacuum coating method, in which a flux having a low melting point compared to conventional selenization heat temperature is used in the step of forming a precursor thin film so that final heat treatment temperature can be lowered while crystal growth can be sufficiently enabled.

### Background Art

Solar cells are classified according to the material of their light absorption layer and at present silicon-based solar cells are most frequently used. However, in recent years, as the price of the silicon-based solar cells has risen suddenly due to lack of the supply of silicon, interest in thin film type solar cells has increased. Because thin film type solar cells are fabricated to be thin, the consumption of the materials is reduced, and because these solar cells are light in weight they are used in a wide range of applications. Studies on amorphous silicon and CdTe, CIS or CIGS, which are the materials of such thin film type solar cells, have been actively conducted.

A CIS thin film or a CIGS thin film is one of I-III-VI compound semiconductors and shows the highest conversion efficiency (20.3%) among experimentally fabricated thin film solar cells. Particularly, it can be fabricated to have a thickness of 10 µm or less and is stable even when it is used for a long period of time, and thus its use is expected in production of inexpensive high-efficiency solar cells capable of substituting silicon-based solar cells.

The CIGS-based thin film is a material developed by substituting a portion of In with Ga or substituting S with Se in order to improve the low open-circuit voltage of the CIS thin film. The CIGS-based solar cell is fabricated with a thin film having a thickness of a few microns, and fabrication methods thereof include a vacuum vapor deposition method and a method in which a precursor material is applied in a non-vacuum, and then heat-treated.

The CIGS-based thin film formed by applying the precursor material in a non-vacuum is highly porous and is not dense, and for this reason, the selenization heat treatment thereof is performed. The selenization heat treatment should be performed at a temperature of 500 °C or higher, because the melting point of CuSe that assists in the growth of crystals in the CIGS thin film is 500 °C or higher. Thus, there is the problem in that the fabrication cost of the CIGS-based thin film increases.

The contents associated with the Background Art can be found in Korean Patent Registration Nos. 10-1030780 and 10-1039667 and the like.

US 2007/0163644 A1 discloses a method for fabricating a CI(G)S-based thin film for a solar cell, comprising coating in a non-vacuum a substrate with an ink containing CI(G)S-based nanoparticles to form a precursor layer, and heating the precursor layer in a substantially oxygen-free chalcogen atmosphere to a processing temperature sufficient to react the particles and release chalcogen from the particles, wherein the chalcogen assumes a liquid form and acts as a flux to improve the intermixing of elements.

### Disclosure

### Technical Problem

An object of the present invention is to fabricate a CI(G)S-based thin film for a solar cell under non-vacuum conditions, in which a precursor thin film comprising a flux having a low melting point is formed so that the growth of crystals in the thin film is sufficiently enabled even when the selenization heat treatment of the thin film is performed at a lower temperature than that in the prior art, thereby increasing the efficiency of a solar cell comprising the thin film.

### Technical Solution

In order to accomplish the above object, the present invention provides a method for fabricating a CI(G)S-based thin film for a solar cell using a flux having a low melting point, the method being as defined in claim 1.

The CI (G) S-based nanoparticles may be any one of binary nanoparticles including any one or more selected from the group consisting of Cu-Se, In-Se, Ga-Se, Cu-S, In-S and Ga-S particles; ternary nanoparticles including any one or more selected from the group consisting of Cu-In-Se, Cu-In-S, Cu-GaS and Cu-Ga-Se particles; quaternary nanoparticles of Cu-In-Ga-Se; quinary nanoparticles including any one or more selected from the group consisting of Cu-In-Ga-Se-(S,Se) and Cu-In-Al-Ga-(S,Se); senary nanoparticles of Cu-In-Al-Ga-Se-S; and nanoparticles including any one or more selected from the group consisting of Cu, In, Ga, Al, S and Se element powders.

Step (a) may be performed by any one of a low-temperature colloidal method, a solvothermal synthesis method, a microwave method and an ultrasonic synthesis method.

The slurry in step (b) is prepared by mixing the CI (G) S nanoparticles, the flux, a solvent, a chelating agent and a binder.

The flux is any one selected from the group consisting of sulfamide, sodium selenate decahydrate, sodium selenite, and sulfamic acid.

Step (c) may be performed by any one of a spray method, an ultrasonic spray method, a spin coating method, a doctor blade method, a screen printing method and an inkjet printing method.

Step (d) may be performed by drying the precursor thin film at a temperature of 60 to 300 °C for 2-10 minutes, in which the drying may be repeated 2 to 10 times.

The selenization heat treatment in step (e) is performed at a temperature of 250 to 450 °C for 30-120 minutes.

An aspect of the disclosure further concerns a method for fabricating a CI(G)S-based thin film for a solar cell using a flux having a low melting point, the method comprising the steps of: (1) preparing a CI(G)S-based precursor solution containing a flux having a melting point of 30 to 400 °C; (m) coating a substrate with the CI (G) S-based precursor solution containing the flux in a non-vacuum to form a CI(G)S-based precursor thin film; (n) drying the CI(G)S-based precursor thin film; and (o) performing selenization heat treatment of the CI(G)S-based precursor thin film using selenium vapor.

The CI (G) S-based precursor solution may include a metal salt solution containing each of Cu, In and Ga, and a hydrazine solution containing CI(G)S-based nanoparticles.

The CI (G) S-based nanoparticles may be any one of binary nanoparticles including any one or more selected from the group consisting of Cu-Se, In-Se, Ga-Se, Cu-S, In-S and Ga-S particles; ternary nanoparticles including any one or more selected from the group consisting of Cu-In-Se, Cu-In-S, Cu-GaS and Cu-Ga-Se particles; quaternary nanoparticles of Cu-In-Ga-Se; quinary nanoparticles including any one or more selected from the group consisting of Cu-In-Ga-Se-(S,Se) and Cu-In-Al-Ga-(S,Se); senary nanoparticles of Cu-In-Al-Ga-Se-S; and nanoparticles including any one or more selected from the group consisting of Cu, In, Ga, Al, S and Se element powders.

The metal salt solution may be any one selected from the group consisting of chloride, acetate, nitrate and sulfate.

Step (m) may be performed by any one of a spray method, an ultrasonic spray method, a spin coating method, a doctor blade method, a screen printing method and an inkjet printing method.

The selenization heat treatment in step (o) may be performed in a temperature of 250 to 450 °C for 30-120 minutes.

According to a further aspect of the disclosure, a CI(G)S-based thin film for a solar cell may be fabricated using a flux having a low melting point by a method comprising the steps of: preparing CI(G)S-based nanoparticles; preparing a slurry including the CI(G)S-based nanoparticles and a flux having a melting point of 30 to 400 °C; coating the slurry on a substrate in a non-vacuum to form a CI(G)S-based precursor thin film; drying the CI(G)S-based precursor thin film; and performing selenization heat treatment of the CI(G)S-based precursor thin film using selenium vapor.

In yet a further aspect of the disclosure, a CI(G)S-based thin film for a solar cell may be fabricated using a flux having a low melting point by a method comprising the steps of: preparing a CI(G)S-based precursor solution containing a flux having a melting point of 30 to 400 °C; coating a substrate with the CI(G)S-based precursor solution containing the flux in a non-vacuum to form a CI(G)S-based precursor thin film; drying the CI(G)S-based precursor thin film; and performing selenization heat treatment of the CI(G)S-based precursor thin film using selenium vapor.

### Advantageous Effects

According to the present invention, in a process of fabricating a CI(G)S-based thin film for a solar cell under non-vacuum conditions, a precursor thin film comprising a flux having a low melting point is formed. Accordingly, selenization heat treatment of the precursor thin film can be performed at a low temperature compared to that in the prior art, and thus the fabrication cost can be reduced, while the growth of crystals in the thin film can be sufficiently enabled even at a low temperature.

### Description of Drawings

FIG. 1 is a flow chart sequentially showing a method for fabricating a CI(G)S-based thin film for a solar cell according to the present invention.
FIG. 2 is a flow chart sequentially showing another method for fabricating a CI (G) S-based thin film for a solar cell according to a further aspect of the present disclosure.

### Mode for Invention

A method for fabricating a CI (G) S-based thin film for a solar cell according to the present invention is performed using non-vacuum coating, in which the non-vacuum coating may be performed by a method that uses a slurry containing CI(G)S-based nanoparticles or a method that uses a CI(G)S metal salt precursor solution.

The method that uses the slurry containing the CI(G)S-based nanoparticles will be first described, and then the method that uses the CI(G)S metal salt precursor solution will be described.

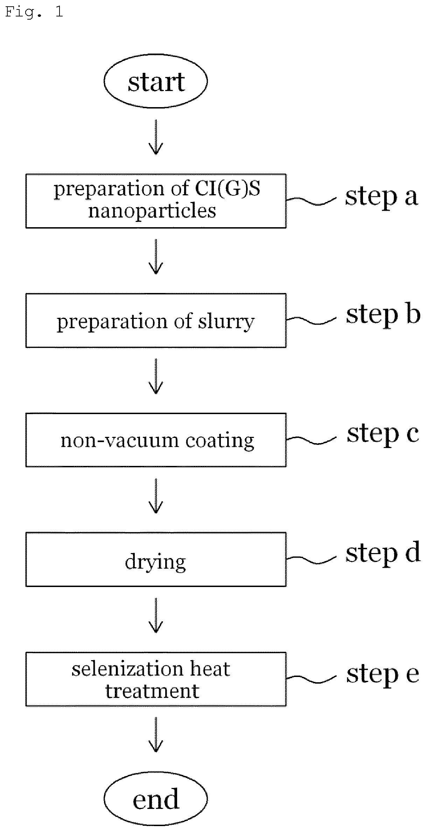

Hereinafter, the inventive method for fabricating the CI(G)S-based thin film will be described with reference to FIG. 1. The method for fabricating the CI (G) S-based thin film can be divided into a total of five steps.

First, CI(G)S nanoparticles are prepared (step a).

The CI(G)S nanoparticles may be a mixture of binary nanoparticles, such as Cu-Se, In-Se, Ga-Se, Cu-S, In-S and GaS. In some cases, the CI (G) S nanoparticles may be nanoparticles including a ternary compound, such as Cu-In-S, Cu-Ga-S or Cu-Ga-Se, which is based on Cu-In-Se that is a IB-IIIA-VIA group compound semiconductor, a quaternary compound such as Cu-In-Ga-Se, or a quinary or senary compound such as Cu-In-Ga-Se-(S,Se), Cu-In-Al-Ga-(S,Se) or Cu-In-Al-Ga-Se-S.

In addition, depending on the kind of compound, element powder such as Cu, In, Ga, Al, S or Se may also be used.

The CI(G)S nanopaprticles can be prepared according to a method known in the art, such as a low-temperature colloidal method, a solvothermal synthesis method, a microwave method or an ultrasonic synthesis method.

Next, a slurry containing a low-temperature flux and the CI(G)S nanoparticles is prepared (step b).

The slurry is prepared by mixing the CI(G)S nanoparticles prepared in step (a), a solvent, a chelating agent, a binder and a low-temperature flux.

Herein, the solvent may be an alcohol such as methanol, ethanol, pentanol, propanol or butanol, ether, ketone, or glycol ether (cellosolve).

The chelating agent may be an amine compound such as MEA (monoethanolamine), DEA (diethanolamine), TEA (triethanolamine), ethylenediamine, EDTA (ethylenediaminetetraacetic acid), NTA (nitrilotriacetic acid), HEDTA (hydroxyethyl ethylenediamine triacetic acid), GEDTA (glycol ether diamine tetraacetic acid), TTHA (triethylene tetraamine hexaacetic acid) or the like.

Meanwhile, a small amount of water as a solvent may be added to the slurry in order to facilitate the mixing of the low-temperature flux.

The binder may be a polyalcohol such as ethylene glycol, propylene glycol or the like.

As used herein, the term "low-temperature flux" refers to a material having a melting point of 400 °C or below, and preferably 30 to 400 °C, which is lower than the melting point of CuSe that assists in the growth of crystals in the CI(G)S-based thin film according to the prior art. Also, the term is defined as a material that is melted at a relatively low temperature during the selenization heat treatment of the in the fabrication of the CI(G)S-based thin film according to the present invention to facilitate the migration of elements and assist in crystal growth.

The low-temperature flux that is used in the present invention may be sulfamide, sodium selenate decahydrate, sodium selenite, and sulfamic acid.

The profiles of the above low-temperature fluxes are shown in Table 1 below.

**Table 1**

| Name | Chemical formula | CAS/Aldrich | Molecular weight | Melting point (°C) |
|---|---|---|---|---|
| Sulfamide | (NH₂)₂SO₂ | 7803-58-9 / 211370 | 96.11 | 90 ∼ 92 |
| Sodium selenate decahydrate | Na₂SeO₄-10H₂O | 10102-23-5/ 450294 | 369.09 | 35 |
| Sodium selenite | Na₂SeO₃ | 10102-18-8/ 24485 | 172.94 | 350 |
| Sulfamic acid | NH₂SO₃H | 5329-14-6/481505 | 97.09 | ∼220 |

As shown in Table 1 above, the above low-temperature fluxes can be melted at a temperature of 350 °C or below, and thus facilitate the migration of elements at a temperature lower than a conventional selenization heat treatment temperature (500 °C) to assist in the growth of crystals in the CI(G)S-based thin film.

As is known in the art, the Na element contained in the low-temperature fluxes can assists in the growth of crystals in the CI (G) S-based thin film, Se and S may be the constituent elements of the thin film, and N and O are impurities that have little or no influence on the properties of the CI(G)S-based thin film. In addition, O is evaporated in the selenization heat treatment process, and thus does not remain in the thin film.

Next, the slurry is coated on a substrate to form a CI(G)S-based precursor thin film (step c).

Formation of the CI(G)S-based precursor thin film is characterized in that a non-vacuum coating method is used. The non-vacuum coating method may be any non-vacuum coating method known in the art, such as a spray method, an ultrasonic spray method, a spin coating method, a doctor blade method, a screen printing method or an inkjet printing method. The use of this non-vacuum coating method can reduce the fabrication cost compared to a co-evaporation method.

Next, the coated CI(G)S-based precursor thin film is dried (step d).

The drying is performed at a temperature of 60 to 300 °C for 2-10 minutes, and the drying process is preferably repeated 2 to 10 times.

Thus, the solvent and the binder can be removed.

Finally, selenization heat treatment of the CI(G)S-based thin film is performed using selenium (Se) vapor (step e).

The heat treatment process using selenium vapor may be performed by increasing the temperature of the substrate having the thin film formed thereon while supplying selenium vapor formed by heating a selenium solid.

Herein, the selenization heat treatment process is preferably performed for 30-120 minutes at a substrate temperature of 250 to 450 °C, which is lower than that in the conventional selenization heat treatment process.

Thus, the CI (G) S-based precursor thin film can be selenized, and the low-temperature flux can be melted while crystal growth can be made.

The disclosure further concerns a CI (G) S-based thin film fabricated according to the above fabrication method.

The disclosure further yet concerns a solar cell comprising the CI (G) S-based thin film as a light absorption layer.

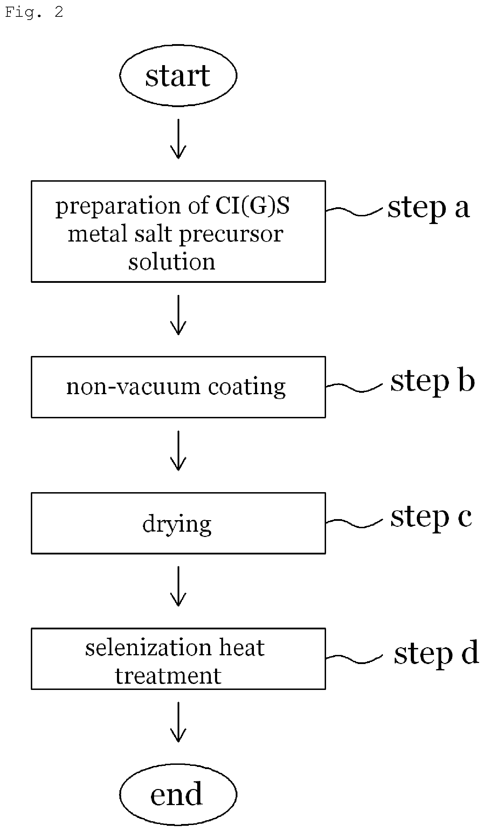

Hereinafter, another method for fabricating a CI(G)S-based thin film for a solar cell will be described. The fabrication method is performed using a CI(G)S precursor solution. FIG. 2 sequentially shows the fabrication method.

Referring to FIG. 2, a CI(G)S-based precursor solution containing a low-temperature flux is first prepared (step 1).

The CI(G)S-based precursor solution is composed of a metal salt solution containing each of Cu, In and Ga and a hydrazine solution containing any one of binary, ternary, quaternary, quinary and senary CIS, CIGS and CZTS-based compound nanoparticles including Se or S. The compound nanoparticles are as described above with respect to step (a) of the method for fabricating the CI(G)S-based thin film, and thus the detailed description thereof is omitted.

Herein, the metal salt solution may contain an alcohol-based solvent or water as a solvent. In addition, the metal salt in the metal salt solution may be an organic or inorganic salt such as chloride, acetate, nitrate or sulfate.

In addition, the binary compounds containing Se include Cu₂Se, In₂Se₃ and Ga₂Se₃ nanoparticles to which Se may further be added.

The low-temperature flux is described in Table 1 with respect to step (b) of the method for fabricating the CI(G)S-based on thin film using the slurry, and thus the detailed description thereof is omitted.

Next, the CI (G) S-based precursor solution containing the low-temperature flux is coated on a substrate to form a CI(G)S-based precursor thin film (step m).

Formation of the CI(G)S-based precursor thin film is characterized in that a non-vacuum coating method is used. Specifically, the non-vacuum coating method may be any non-coating method known in the art, such as a spray method, an ultrasonic spray method, a spin coating method, a doctor blade method, a screen printing method and an inkjet printing method.

Next, the coated CI(G)S-based thin film is dried (step n).

Finally, selenization heat treatment of the CI(G)S-based precursor thin film is performed using selenium vapor (step o).

The method and conditions that are used in steps (n) and (o) are as described above with respect to steps (d) and (e) of the method for fabricating the CI (G) S-based thin film for a solar cell, and thus the detailed description thereof is omitted.

The disclosure further concerns a CI (G) S-based thin film fabricated according to the above fabrication method.

The disclosure further yet concerns a solar cell comprising the CI (G) S-based thin film as a light absorption layer.

### Example 1

In a glove box, 0.343 g of CuI, 0.673 g of InI₃ and 0.207 g of GaI₃ were mixed with 30 Mℓ of a distilled pyridine solvent, and the mixture was stirred on a hot plate at 100 °C for about 30 minutes. After stirring for about 10 minutes, it was observed that the non-transparent solution became transparent. This Cu/In mixture was mixed with a solution of 0.48 g of Na₂Se in 20 Mℓ of methanol. The resulting mixture had an atomic ratio of Cu : In : Ga : Se = 0.9 : 0.68 : 0.23 : 1.91.

Next, the methanol/pyridine mixture was allowed to react in an ice bath at 0 °C for 1 minute while it was mechanically stirred, thereby synthesizing CIGS colloids. The synthesized CIGS colloids were centrifuged at 4000 rpm for about 30 minutes, treated ultrasonically for 5 minutes and then washed with distilled methanol, and this procedure was repeated to completely remove byproducts and pyridine from the product, thereby synthesizing high-purity Cu-In-Ga-Se nanoparticles.

Next, 0.3 g of the Cu-In-Ga-Se nanoparticles, 0.3 g of a chelating agent, 0.3 g of ethylene glycol, 1.2 g of methanol, 0.03 g of sulfamide as a low-temperature flux and a small amount of water as a solvent for the low-temperature flux were mixed with each other, and the mixture was ultrasonically treated for 60 minutes, thereby preparing a slurry.

Then, the slurry was coated on a soda lime glass substrate having a Mo thin film deposited thereon using a spin coating method. Herein, the glass substrate was rotated at a speed of 800 rpm for 20 seconds. After coating, the coated slurry was subjected to a three-step drying process consisting of a first drying step at 60 °C for 5 min, a second drying step at 200 °C for 2 min and a third drying step at 300 °C for 10 min.

Finally, selenization heat treatment of the dried thin film was performed at a substrate temperature of 400 °C for 30 minutes while supplying Se vapor, thereby fabricating a CIGS-based thin film.

### Example 2

In a glove box, 0.343 g of CuI and 0.991 g of InI₃ were mixed with 30 ml of a distilled pyridine solvent, and the mixture was stirred on a hot plate at 50 °C for about 10 minutes. After stirring for about 10 minutes, it was observed that the non-transparent solution became transparent. This Cu/In mixture was mixed with a solution of 0.5 g of Na₂Se in 20 ml of distilled methanol. The resulting mixture had an atomic ratio of Cu : In : Se = 0.9 : 1 : 2.

Next, the methanol/pyridine mixture was allowed to react in an ice bath at 0 °C for 1 minute while it was mechanically stirred, thereby synthesizing nanoparticles. The synthesized CIS colloids were centrifuged at 4000 rpm for about 30 minutes, treated ultrasonically for 5 minutes and then washed with distilled methanol, and this procedure was repeated to completely remove byproducts and pyridine from the product, thereby synthesizing high-purity Cu-In-Se nanoparticles.

A CIS-based thin film was fabricated using 0.3 g of the Cu-In-Se nanoparticles in the same manner as described in Example 1.

### Example 3

In a glove box, 0.762 g of CuI was mixed with 30 ml of a distilled pyridine solvent, and the mixture was stirred on a hot plate at 100 °C for about 30 minutes. After stirring for about 10 minutes, it was observed that the non-transparent solution became transparent. This Cu solution was mixed with a solution of 0.25 g of Na₂Se in 10 ml of distilled methanol. The resulting mixture had an atomic ratio of Cu : Se = 1 : 2. Next, the methanol/pyridine mixture was allowed to react in an ice bath at 0 °C for 1 minute while it was mechanically stirred, thereby synthesizing Cu₂Se colloids. The synthesized Cu₂Se colloids were centrifuged at 4000 rpm for about 30 minutes, treated ultrasonically for 5 minutes and then washed with distilled methanol, and this procedure was repeated to completely remove byproducts and pyridine from the product, thereby synthesizing high-purity Cu₂Se particles.

Meanwhile, in a glove box, 1.487 g of InI₃ was mixed with 30 ml of a distilled pyridine solvent, and the mixture was stirred on a hot plate at 100 °C for about 30 minutes. After stirring for about 10 minutes, it was observed that the non-transparent solution became transparent. This In solution was mixed with a solution of 0.75 g of Na₂Se in 20 ml of distilled methanol. The resulting mixture had an atomic ratio of In : Se = 2 : 3. Next, the methanol/pyridine mixture was allowed to react in an ice bath at 0 °C for 1 minute while it was mechanically stirred, thereby synthesizing In₂Se₃ colloids. The synthesized In₂Se₃ colloids were centrifuged at 4000 rpm for about 30 minutes, treated ultrasonically for 5 minutes and then washed with distilled methanol, and this procedure was repeated to completely remove byproducts and pyridine from the product, thereby synthesizing high-purity In₂Se₃ particles.

Meanwhile, in a glove box, 1.80 g of GaI₃ was mixed with 50 ml of a distilled pyridine solvent, and the mixture was stirred on a hot plate at 100 °C for about 30 minutes. After stirring for about 10 minutes, it was observed that the non-transparent solution became transparent. This Ga solution was mixed with a solution of 0.75 g of Na₂Se in 20 ml of distilled methanol. The resulting mixture had an atomic ratio of Ga : Se = 2 : 3. Next, the methanol/pyridine mixture was allowed to react in an ice bath at 0 °C for 1 minute while it was mechanically stirred, thereby synthesizing Ga₂Se₃ colloids. The synthesized Ga₂Se₃ colloids were centrifuged at 4000 rpm for about 30 minutes, treated ultrasonically for 5 minutes and then washed with distilled methanol, and this procedure was repeated to completely remove byproducts and pyridine from the product, thereby synthesizing high-purity Ga₂Se₃ particles.

The Cu₂Se, In₂Se₃ and Ga₂Se₃ nanoparticles synthesized as described above were mixed with each other, and 0.3 g of the mixture was prepared. A slurry was prepared using the nanoparticle mixture in the same manner as described in Example 1, and a CIGS-based thin film was fabricated using the slurry.

### Example 4

Cu-In-Ga-Se nanoparticles were prepared in the same manner as described in Example 1, and a CIGS metal salt solution containing the low-temperature flux sodium selenate decahydrate was prepared using the nanoparticles.

In the same manner as described in Example 1, the CIGS metal salt solution was coated on a soda lime glass substrate having a Mo thin film deposited thereon using a spin coating method, and the coated solution was dried, followed by selenization heat treatment, thereby fabricating a CIGS-based thin film.

### Example 5

Cu-In-Se nanoparticles were prepared in the same manner as described in Example 2, and a CIG metal salt solution containing the low-temperature flux sodium selenate decahydrate was prepared using the nanoparticles.

In the same manner as described in Example 1, the CIGS metal salt solution was coated on a soda lime glass substrate having a Mo thin film deposited thereon using a spin coating method, and the coated solution was dried, followed by selenization heat treatment, thereby fabricating a CIGS-based thin film.

### Example 6

Cu₂Se, In₂Se₃ and Ga₂Se₃ nanoparticles were prepared in the same manner as described in Example 3, and a CIG metal salt solution containing the low-temperature flux sodium selenate decahydrate was prepared using the nanoparticles.

In the same manner as described in Example 1, the CIGS metal salt solution was coated on a soda lime glass substrate having a Mo thin film deposited thereon using a spin coating method, and the coated solution was dried, followed by selenization heat treatment, thereby fabricating a CIGS-based thin film.

## Claims

1. A method for fabricating a CI(G)S-based thin film for a solar cell using a flux having a low melting point, the method comprising the steps of:
(a) preparing CI(G)S-based nanoparticles;
(b) preparing a slurry containing the CI(G)S-based nanoparticles and a flux having a melting point of 30 to 400 °C;
(c) coating the slurry on a substrate in a non-vacuum to form a CI(G)S-based precursor thin film;
(d) drying the CI(G)S-based precursor thin film; and
(e) performing selenization heat treatment of the CI(G)S-based precursor thin film using selenium (Se) vapor at a temperature of 250 to 450 °C for 30-120 minutes, **characterized in that** the flux is any one selected from the group consisting of sulfamide, sodium selenate decahydrate, sodium selenite and sulfamic acid.

2. The method of claim 1, wherein the CI(G)S-based nanoparticles are any one of binary nanoparticles including any one or more selected from the group consisting of Cu-Se, In-Se, Ga-Se, Cu-S, In-S and Ga-S particles; ternary nanoparticles including any one or more selected from the group consisting of Cu-In-Se, Cu-In-S, Cu-Ga-S and Cu-Ga-Se particles; quaternary nanoparticles of Cu-In-Ga-Se; quinary nanoparticles including any one or more selected from the group consisting of Cu-In-Ga-Se-(S,Se) and Cu-In-Al-Ga-(S,Se); senary nanoparticles of Cu-In-Al-Ga-Se-S; and nanoparticles including any one or more selected from the group consisting of Cu, In, Ga, Al, S and Se element powders.

3. The method of claim 1, wherein step (a) is performed by any one of a low-temperature colloidal method, a solvothermal synthesis method, a microwave method and an ultrasonic synthesis method.

4. The method of claim 1, wherein the slurry in step (b) is prepared by mixing the CI (G) S nanoparticles, the flux, a solvent, a chelating agent and a binder.

5. The method of claim 1, wherein step (c) is performed by any one of a spray method, an ultrasonic spray method, a spin coating method, a doctor blade method, a screen printing method and an inkjet printing method.

6. The method of claim 1, wherein the slurry includes a metal salt solution containing each of Cu, In and Ga, and a hydrazine solution containing CI(G)S-based nanoparticles.

7. The method of claim 6, wherein the CI (G)S-based nanoparticles are any one of binary nanoparticles including any one or more selected from the group consisting of Cu-Se, In-Se, Ga-Se, Cu-S, In-S and Ga-S particles; ternary nanoparticles including any one or more selected from the group consisting of Cu-In-Se, Cu-In-S, Cu-Ga-S and Cu-Ga-Se particles; quaternary nanoparticles of Cu-In-Ga-Se; quinary nanoparticles including any one or more selected from the group consisting of Cu-In-Ga-Se-(S,Se) and Cu-In-Al-Ga-(S,Se); senary nanoparticles of Cu-In-Al-Ga-Se-S; and nanoparticles including any one or more selected from the group consisting of Cu, In, Ga, Al, S and Se element powders.

8. The method of claim 6, wherein the metal salt solution is any one selected from the group consisting of chloride, acetate, nitrate and sulfate.

9. The method of claim 6, wherein step (c) is performed by any one of a spray method, an ultrasonic spray method, a spin coating method, a doctor blade method, a screen printing method and an inkjet printing method.

## Patentansprüche

1. Verfahren zur Herstellung einer CI(G)S-basierten Dünnschicht für Solarzellen unter Verwendung eines Flussmittels mit niedrigem Schmelzpunkt, wobei das Verfahren folgende Schritte aufweist:
(a) Aufbereiten von CI(G)S-basierten Nanopartikeln;
(b) Aufbereiten einer Suspension, die die CI(G)S-basierten Nanopartikel und ein Flussmittel mit einem Schmelzpunkt zwischen 30° und 400°C enthält;
(c) Aufbringen ohne Vakuum der Suspension auf ein Substrat, um eine CI(G)S-basierte Vorläufer-Dünnschicht auszubilden;
(d) Trocknen der CI(G)S-basierten Vorläufer-Dünnschicht; und
(e) Durchführen einer Selenisierungs-Wärmebehandlung der CI(G)S-basierten Vorläufer-Dünnschicht unter Verwendung von Selen (Se)-Dampf bei einer Temperatur zwischen 250° und 450°C für 30 bis 120 Minuten,
**dadurch gekennzeichnet, dass**
das Flussmittel ausgewählt ist aus der Gruppe bestehend aus Sulfit, Natriumselenat-Decahydrat, Natriumselenit, Amidosulfonsäure.

2. Verfahren gemäß Anspruch 1, wobei die CI(G)S-basierten Nanopartikel eines der folgenden sind:
- binären Nanopartikel, die eines oder mehrere Partikel enthalten, ausgewählt aus der Gruppe bestehend aus Cu-Se, In-Se, Ga-Se, Cu-S, In-S und Ga-S;
- ternäre Nanopartikel, die eines oder mehrere Partikel enthalten, ausgewählt aus der Gruppe bestehend aus Cu-In-Se, Cu-In-S, Cu-Ga-S und Cu-Ga-Se;
- quartäre Nanopartikel von Cu-In-Ga-Se;
- quinäre Nanopartikel, die eines oder mehrere Partikel enthalten, ausgewählt aus der Gruppe bestehend aus Cu-In-Ga-Se-(S,Se) und Cu-In-Al-Ga-(S,Se);
- senäre Nanopartikel von Cu-In-Al-Ga-Se-S; und
- Nanopartikel, die einen oder mehrere Pulver enthalten, ausgewählt aus der Gruppe bestehend aus Cu, In, Ga, AI ,S und Se.

3. Verfahren gemäß Anspruch 1, wobei Schritt (a) mittels einem Niedertemperatur-Kolloidalverfahren, einem Solvothermalsynthese oder einem Mikrowellen-Verfahren oder einem Ultraschallsynthese-Verfahren durchgeführt wird.

4. Verfahren gemäß Anspruch 1, wobei die Suspension in Schritt (b) durch Mischen der CI(G)S-basierten Nanopartikel, des Flussmittels, eines Lösungsmittels, eines Komplexbildners und eines Binders aufbereitet wird.

5. Verfahren gemäß Anspruch 1, wobei Schritt (c) durch ein Sprühverfahren, ein Ultraschall-Sprühverfahren, eine Rotationsbeschichtung, ein Aufstreichverfahren, ein Siebdruckverfahren oder ein Tintenstrahldruckverfahren durchgeführt wird.

6. Verfahren gemäß Anspruch 1, wobei die Suspension eine Metallsalzlösung enthält, die Cu und In und Ga und eine Hydrazinlösung mit den CI(G)S-basierten Nanopartikeln enthält.

7. Verfahren gemäß Anspruch 6, wobei die CI(G)S-basierten Nanopartikel eines der folgenden sind:
- binäre Nanopartikel, die eines oder mehrere Partikel enthalten, ausgewählt aus der Gruppe bestehend aus Cu-Se, In-Se, Ga-Se, Cu-S, In-S und Ga-S;
- ternäre Nanopartikel, die eines oder mehrere Partikel enthalten, ausgewählt aus der Gruppe bestehend aus Cu-In-Se, Cu-In-S, Cu-Ga-S und Cu-Ga-Se;
- quartäre Nanopartikel von Cu-In-Ga-Se;
- quinäre Nanopartikel, die eines oder mehrere Partikel enthalten, ausgewählt aus der Gruppe bestehend aus Cu-In-Ga-Se-(S,Se) und Cu-In-Al-Ga-(S,Se);
- senäre Nanopartikel von Cu-In-Al-Ga-Se-S; oder
- Nanopartikel, die einen oder mehrere Pulver enthalten, ausgewählt aus der Gruppe bestehend aus Cu, In, Ga, Al, S und Se.

8. Verfahren gemäß Anspruch 6, wobei die Metallsalzlösung ausgewählt ist aus der Gruppe bestehend aus Chloriden, Acetaten, Nitraten und Sulfaten.

9. Verfahren gemäß Anspruch 6, wobei Schritt (c) durch ein Sprühverfahren, ein Ultraschall-Sprühverfahren, eine Rotationsbeschichtung, ein Aufstreichverfahren, ein Siebdruckverfahren oder ein Tintenstrahldruckverfahren durchgeführt wird.

## Revendications

1. Procédé pour fabriquer un film mince à base de Cl (G)S pour une cellule solaire à l'aide d'un flux présentant un point de fusion bas, le procédé comprenant les étapes de :
(a) préparation de nanoparticules à base de Cl (G)S ;
(b) préparation d'une suspension contenant les nanoparticules à base de Cl (G)S et un flux présentant un point de fusion de 30 à 400 °C ;
(c) étalement de la suspension sur un substrat sans vide pour former un film mince de précurseur à base de Cl (G)S ;
(d) séchage du film mince de précurseur à base de Cl (G)S ; et
(e) réalisation d'un traitement thermique de sélénisation du film mince de précurseur à base de Cl (G)S à l'aide de vapeur de sélénium (Se) à une température de 250 à 450 °C pendant 30 à 120 minutes, **caractérisé en ce que** le flux est l'un quelconque sélectionné à partir du groupe constitué de sulfamide, de décahydrate de sélénate de sodium et d'acide sulfamique.

2. Procédé selon la revendication 1, dans lequel les nanoparticules à base de Cl (G)S sont l'une quelconque de nanoparticules binaires incluant l'une quelconque ou les unes quelconques sélectionnées à partir du groupe constitué de particules de Cu-Se, In-Se, Ga-Se, Cu-S, In-S et Ga-S ; de nanoparticules ternaires incluant l'une quelconque ou les unes quelconques sélectionnées à partir du groupe constitué de particules de Cu-In-Se, Cu-In-S, Cu-Ga-S et Cu-Ga-Se ; de nanoparticules quaternaires de Cu-In-Ga-Se ; de nanoparticules quinaires incluant l'une quelconque ou les unes quelconques sélectionnées à partir du groupe constitué de Cu-In-Ga-Se-(S,Se) et Cu-In-Al-Ga-(S,Se) ; de nanoparticules sénaires de Cu-In-Al-Ga-Se-S ; et de nanoparticules incluant l'une quelconque ou les unes quelconques sélectionnées à partir du groupe constitué de poudres d'éléments Cu, In, Ga, Al, S et Se.

3. Procédé selon la revendication 1, dans lequel l'étape (a) est réalisée par l'un quelconque d'un procédé colloïdal à basse température, d'un procédé de synthèse solvothermique, d'un procédé à micro-ondes et d'un procédé de synthèse par ultrasons.

4. Procédé selon la revendication 1, dans lequel la suspension à l'étape (b) est préparée en mélangeant les nanoparticules de Ci (G)S, le flux, un solvant, un agent de chélation et un liant.

5. Procédé selon la revendication 1, dans lequel l'étape (c) est réalisée par l'un quelconque d'un procédé de pulvérisation, d'un procédé de pulvérisation par ultrasons, d'un procédé de revêtement par centrifugation, d'un procédé à racle, d'un procédé de sérigraphie et d'un procédé d'impression à jet d'encre.

6. Procédé selon la revendication 1, dans lequel la suspension inclut une solution de sels métalliques contenant chacun du Cu, de l'In et du Ga, et une solution d'hydrazine contenant des nanoparticules à base de CI(G)S.

7. Procédé selon la revendication 6, dans lequel les nanoparticules à base de CI(G)S sont l'une quelconque de nanoparticules binaires incluant l'une quelconque ou les unes quelconques sélectionnées à partir du groupe constitué de particules de Cu-Se, In-Se, Ga-Se, Cu-S, In-S et Ga-S ; de nanoparticules ternaires incluant l'une quelconque ou les unes quelconques sélectionnées à partir du groupe constitué de particules de Cu-In-Se, Cu-In-S, Cu-Ga-S et Cu-Ga-Se ; de nanoparticules quaternaires de Cu-In-Ga-Se ; de nanoparticules quinaires incluant l'une quelconque ou les unes quelconques sélectionnées à partir du groupe constitué de Cu-In-Ga-Se-(S,Se) et Cu-In-Al-Ga-(S,Se) ; de nanoparticules sénaires de Cu-In-Al-Ga-Se-S ; et de nanoparticules incluant l'une quelconque ou les unes quelconques sélectionnées à partir du groupe constitué de poudres d'éléments Cu, In, Ga, Al, S et Se.

8. Procédé selon la revendication 6, dans lequel la solution de sels métalliques est l'une quelconque sélectionnée à partir du groupe constitué de chlorure, d'acétate, de nitrate et de sulfate.

9. Procédé selon la revendication 6, dans lequel l'étape (c) est réalisée par l'un quelconque d'un procédé de pulvérisation, d'un procédé de pulvérisation par ultrasons, d'un procédé de revêtement par centrifugation, d'un procédé à racle, d'un procédé de sérigraphie et d'un procédé d'impression à jet d'encre.
